Europäisches Patentamt

European Patent Office

Office européen des brevets

(11) Veröffentlichungsnummer: **0 222 042**

**A1**

# (12) EUROPÄISCHE PATENTANMELDUNG

(21) Anmeldenummer: **85114514.4**

(22) Anmeldetag: **15.11.85**

(51) Int. Cl.⁴: **H03K 17/06** , **H03K 17/687**

(43) Veröffentlichungstag der Anmeldung:
**20.05.87 Patentblatt 87/21**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(72) Erfinder: **Schat, Hermannus, Ing. grad.**
**Habichtweg 26**
**D-7800 Freiburg I.Br.(DE)**
Erfinder: **Novotny, Bernd, Ing. grad.**
**Belchenstrasse 12**
**D-7803 Gundelfingen(DE)**

(74) Vertreter: **Morstadt, Volker, Dipl.-Ing.**
**c/o Deutsche ITT Industries GmbH**
**Patent/Lizenzabteilung Postfach 840**
**Hans-Bunte-Strasse 19**
**D-7800 Freiburg/Brsg.(DE)**

(54) **Schaltungsanordnung mit einem Isolierschicht-Feldeffekttransistor und einer Spule.**

(57) Die Spule (l) wird betriebsspannungsseitig über den Lateraltransistor (t1) und spannungsnullpunktseitig über den Lateraltransistor (t2) betrieben. Die zur Erzeugung eines möglichst kleinen ON-Widerstandes erforderliche Gate-Source-Spannung (g1) des Lateraltransistors (t1) wird dadurch erzeugt, daß dessen Gate über den Kondensator (c) am Schaltungsnullpunkt, über die Diode (d1) an der Betriebsspannung (u) und über die Diode (d2) am Verbindungspunkt von Spule (l) und Lateraltransistor (t2) angeschlossen ist. Dem Gate dieses Transistors sind Sperrimpulse derartiger Dauer und Frequenz zugeführt, daß der von der Spule (l) erzeugte mechanische Zustand praktisch nicht gestört wird.

FIG.1

EP 0 222 042 A1

## Schaltungsanordnung mit einem Isolierschicht-Feldeffekttransistor und einer Spule

Die Erfindung betrifft eine Schaltungsanordnung mit einer einerseits über den leitend gesteuerten Strompfad eines n-Kanal-Enhancement-Isolierschicht-Feldeffekttransistors am Pluspol einer Betriebsspannungsquelle liegenden und andererseits mit dem Schaltungsnullpunkt gekoppelten, stromdurchflossenen Spule, deren elektromagnetische Feldkraft einen mechanischen Zustand herbeiführt, und mit mindestens einer Diode, vgl. den Oberbegriff des Anspruchs 1.

Eine derartige Schaltungsanordnung ist in der ITT-Firmendruckschrift "VMOS Application Ideas", Freiburg i.Br. , Germany, 1979, auf Seite 6 in Verbindung mit Fig. 8 anhand der Drehzahlsteuerung von Gleichstrommotoren beschrieben. (Die elektromagnetische Feldkraft der jeweiligen Spule der Anordnungen nach den Fig. 4 bis 7 auf den Seiten 5 und 6 a.a.O. erzeugt keinen mechanischen Zustand).

Bei dem Enhancement-Isolierschicht-Feldeffekttransistor nach dem genannten Stand der Technik handelt es sich um einen diskreten VMOS-Transistor.

Soll eine solche Schaltung jedoch mit lateralen n-Kanal-Transistoren, im folgenden kurz Lateraltransistoren genannt, betrieben werden, wie sie beispielsweise auch bei Realisierung in integrierten MOS-Schaltungen praktisch ausschließlich üblich sind sowie in Bipolar-Schaltungen zusätzlich realisiert werden können, und soll die Ein-und Ausschaltung der Spule ebenfalls auf der Pluspol-, und nicht auf der Schaltungsnullpunkt-Seite der Spule erfolgen, so ist das Gate des Lateraltransistors so vorzuspannen, daß er (dauernd) leitend gesteuert ist. Ferner ist er im Hinblick auf die Stromstärke des zu schaltenden Stroms und die Höhe der Betriebsspannung flächenmäßig zu dimensionieren. Bei dieser Dimensionierung ist darauf zu achten, daß der Widerstand des zwischen der Spule und der Betriebsspannungsquelle liegenden Lateraltransistors im leitend gesteuerten Zustand, der sogenannte ON-Widerstand, einen möglichst kleinen Wert aufweist. Dieser Wert ist umso kleiner, je größer die zwischen Gate und Source liegende Spannung ist. Da im leitend gesteuerten Zustand des Lateraltransistors die Source-Spannung praktisch gleich der Betriebsspannung ist, ist eine zusätzliche Spannungsquelle für die Gate-Spannung erforderlich. Da in den meisten Anwendungsfällen eine zusätzliche äußere Betriebsspannungsquelle nicht zur Verfügung steht, muß diese Spannung von der Schaltungsanordnung selbst erzeugt werden.

Die Aufgabe der in den Ansprüchen gekennzeichneten Erfindung beschäftigt sich mit der Lösung dieses Problems, d.h. die vorbeschriebene Schaltungsanordnung soll so modifiziert werden, daß sie an einer einzigen Betriebsspannungsquelle betrieben werden kann und daß der zwischen Spule und Pluspol der Betriebsspannungsquelle liegende Transistor eine mittels der Schaltungsanordnung selbst erzeugten Gate-Spannung betrieben wird, so daß sein ON-Widerstand den geforderten kleinen Wert annehmen kann. Ferner soll die Schaltung monolithisch integrierbar sein.

Mit der Schaltungsanornung nach der Erfindung wird es somit möglich, Spulen zu betreiben, ohne eine weitere äußere Betriebsspannungsquelle vorsehen zu müssen.

Die Erfindung wird nun anhand der Figuren der Zeichnung näher erläutert.

Fig. 1 zeigt als Ausführungsbeispiel die Betriebsschaltung eines Gleichstrommotors,

Fig. 2 zeigt zwei Impulsdiagramme und

Fig. 3 zeigt eine Weiterbildung des Ausführungsbeispiels nach Fig. 1 zu einer Brückenschaltung.

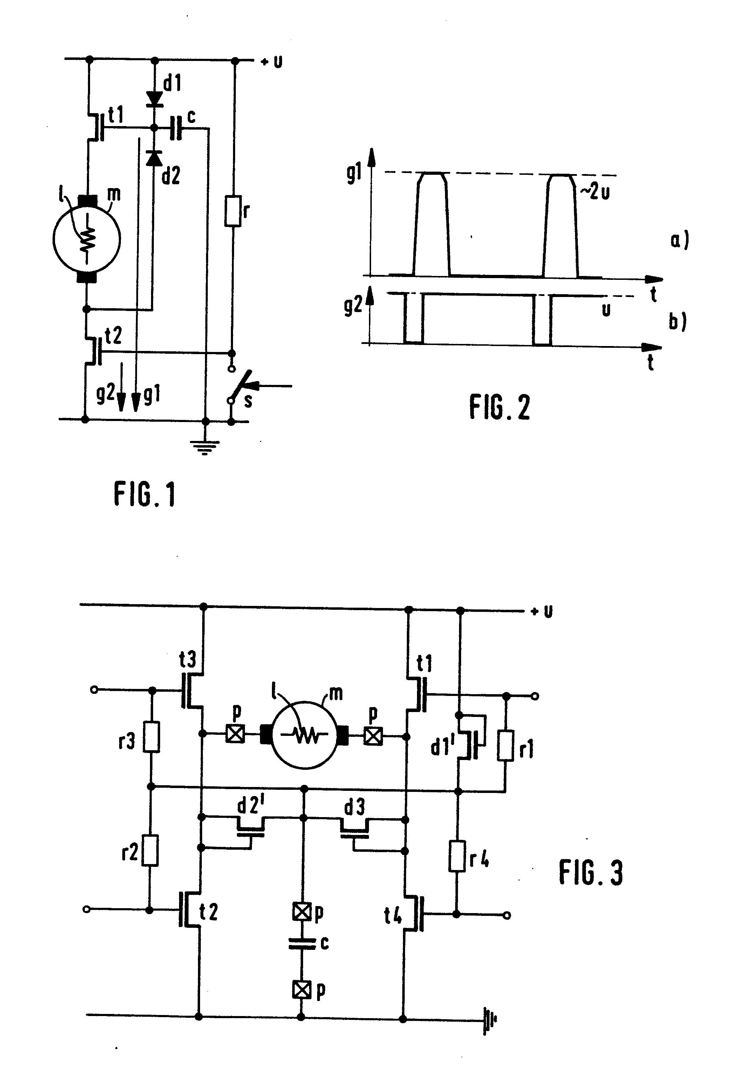

Im Ausführungsbeispiel der Fig. 1 ist die Spule l Teil des Gleichstrommotors m und bewirkt als mechanischen Zustand dessen Drehen. Als Spule l kann natürlich auch beispielsweise die Spule eines Relais dienen, wobei der mechanische Zustand dann dessen angezogener Anker ist. Auch eine in einem Permanentmagnetfeld beweglich angeordnete Spule, die in stromdurchflossenem Zustand eine andere mechanische Lage als im stromlosen Zustand annimmt, ist im Sinne der Erfindung eine Spule, deren elektromagnetische Feldkraft einen mechanischen Zustand herbeiführt.

Im Ausführungsbeispiel der Fig. 1 ist die Spule l über den leitend gesteuerten Strompfad des ersten Lateraltransistors t1 mit dem Pluspol der Betriebsspannungsquelle u verbunden. Das andere Ende der Spule l liegt über den gesteuerten Strompfad des zweiten Lateraltransistors t2 am Schaltungsnullpunkt. Die weiteren in Fig. 1 gezeigten Schaltelemente dienen der Erzeugung der Gate-Spannung des ersten Lateraltransistors t1, damit dieser einen möglichst kleinen ON-Widerstand hat. Hierzu ist das Gate des ersten Lateraltransistors t1 über den Kondensator c mit dem Schaltungsnullpunkt und über die Kathoden-Anoden-Strecke der ersten Diode d1 mit dem Pluspol der Betriebsspannungsquelle u, dagegen über die Kathoden-Anoden-Strecke der zweiten Diode d2 mit dem Verbindungspunkt von Spule l und zweitem Lateraltransistor t2 verbunden.

Ferner ist im Ausführungsbeispiel nach Fig. 1 mittels des Schalters s und des Widerstandes r eine Möglichkeit gezeigt, wie die dem Gate des leitend gesteuerten zweiten Lateraltransistors t2 zuzuführenden Sperrimpulse erzeugt werden können, die eine derartige Dauer und Frequenz aufweisen müssen, daß der von der Spule erzeugte mechanische Zustand praktisch nicht gestört wird, im vorliegenden Ausführungsbeispiel als die Drehung des Motors m praktisch unbeeinflußt bleibt. Hierzu wird mittels entsprechender periodischer Betätigung der Schalter s geschlossen und dadurch der zweite Lateraltransistor t2 kurzzeitig gesperrt, so daß der Stromfluß in der Spule l unterbrochen wird. Dadurch entsteht an deren Verbindungspunkt mit dem zweiten Lateraltransistor t2 ein positiver Spannungsimpuls, der mittels der zweiten Diode d2 zum Kondensator c übertragen wird und dort zum Aufbau der erforderlichen Gate-Spannung g1 führt.

Die Spule ist ausgeschaltet, wenn der Schalter s dauernd geschlossen ist.

In Fig. 2 sind in etwa quantitative Verhältnisse gezeigt; die Gate-Spannung g2 des zweiten Lateraltransistors t2 ist nach Fig. 2b mittels des Widerstandes r bei geöffnetem Schalter s auf den Wert der Betriebsspannung u gelegt. Andererseits hat bei der periodischen Betätigung des Schalters s die Gate-Spannung g1 des ersten Lateraltransistors t1 einen Wert, der bei entsprechender Dimensionierung z.B. etwa der doppelten Betriebsspannung 2u entspricht, so daß die tatsächliche Gate-Source-Spannung des ersten Lateraltransistors t1 etwa gleich der Betriebsspannung u ist und somit der des zweiten Lateraltransistors t2 praktisch gleich ist. Beide Lateraltransistoren nehmen somit bei gleicher flächenmäßiger Dimensionierung denselben ON-Widerstand an.

Die Fig. 3 zeigt eine Erweiterung des Ausführungsbeispiels nach Fig. 1 zur Brückenschaltung. Dazu sind der dritte und der vierte Lateraltransistor t3, t4 vorgesehen, welch erster betriebsspannungsseitig mit dem zweiten Lateraltransistor t2 und welch letzter spannungsnullpunktseitig mit dem ersten Lateraltransistor t1 in Serie liegt. Die beiden Dioden d1, d2 nach Fig. 1 sind als diodengeschaltete laterale Isolierschicht-Feldeffekttransistoren vom n-Kanal-Enhancement-Typ d1', d2' realisiert, ebenso wie im übrigen die dritte Diode d3, die zwischen dem spannungsführenden Anschluß des Kondensators c und dem Verbindungspunkt des ersten und des vierten Lateraltransistors t1, t4 angeordnet ist.

Mittels der kleinen durchkreuzten Quadrate sind die äußeren Anschlüsse p angedeutet, über die der Motor m und der Kondensator c von außen an die integrierte Schaltung anzuschließen sind, falls die Schaltung Teil einer integrierten Schaltung ist.

Die mittels des Kondensators c und der Dioden d1', d2', d3 erzeugte Gate-Spannung g2 des zweiten Lateraltransistors t2 ist den Gates aller vier Lateraltransistoren t1...t4 über die Widerstände r1, r2, r3, r4 zugeführt, so daß die jeweiligen Gates von dieser Spannungsquelle entkoppelt sind und mit entsprechenden Drehzahl-, Drehrichtungs-und Sperrimpulsen gespeist werden können. Diese können mittels Teilschaltungen derselben monolithisch integrierten Schaltung erzeugt werden, wobei diese Teilschaltungen sowohl in Bipolar-als auch in MOS-Technik realisierbar sind.

**Ansprüche**

1. Schaltungsanordnung mit einer einerseits über den leitend gesteuerten Strompfad eines n-Kanal Enhancement-Isolierschicht-Feldeffeckttransistors am Pluspol einer Betriebsspannungsquelle - (u) liegenden und andererseits mit dem Schaltungsnullpunkt gekoppelten stromdurchflossenen Spule (l), deren elektromagnetische Feldkraft einen mechanischen Zustand herbeiführt, und mit mindestens einer Diode, gekennzeichnet durch folgende Merkmale:
-der n-Kanal-Enhancement-Isolierschicht-Feldeffekttransistor ist ein erster Lateraltransistor (t1),
-die Spule (l) liegt über den gesteuerten Strompfad eines zweiten Lateraltransistors (t2) vom n-Kanal-Enhancement-Typ am Schaltungsnullpunkt,
-das Gate des ersten Lateraltransistors (t1) liegt über einen Kondensator (c) am Schaltungsnullpunkt, über die Kathoden-Anoden-Strecke einer ersten Diode (d1) am Pluspol der Betriebsspannungsquelle (u) und über die Kathoden-Anoden-Strecke einer zweiten Diode (d2) am Verbindungspunkt von Spule (l) und zweitem Lateraltransistor - (t2), und
-dem Gate des leitend gesteuerten zweiten Lateraltransistors (t2) sind Sperrimpulse derartiger Dauer und Frequenz zugeführt, daß der von der Spule erzeugte mechanische Zustand praktisch nicht gestört wird.

2. Schaltungsanordnung nach Anspruch 1 mit einer Wicklung eines Gleichstrommotors (m) als Spule (l), dadurch gekennzeichnet, daß mittels eines dritten und eines vierten Lateraltransistors (t3, t4) vom n-Kanal-Enhancement-Typ sowie einer dritten Diode (d3) die Schaltung zu einer Brückenschaltung erweitert ist.

3. Schaltungsanordnung nach Anspruch 1 oder 2, dadurch gekennzeichnet, daß diodengeschaltete laterale Isolierschicht-Feldeffekttransistoren vom n-Kanal-Enhancement-Typ als Dioden (d...) dienen und daß diese sowie die Lateraltransistoren (t...) Teil einer monolithisch integrierten Schaltung sind.

FIG.1

FIG.2

FIG.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | WO-A-8 404 635 (MOTOROLA INC.) * Zusammenfassung; Seite 3, Zeile 30 - Seite 7, Zeile 2; Figuren 1, 2 * | 1,2 | H 03 K 17/06 H 03 K 17/687 |
| A | PATENT ABSTRACTS OF JAPAN, Band 6, Nr. 205 (E-136)[1083], 16. Oktober 1982; & JP - A - 57 112 135 (SUWA SEIKUSHA K.K.) 13.07.1982 * Zusammenfassung, Figur 3 * | 1 | |
| A | EP-A-0 048 758 (INTERNATIONAL RECTIFIER CORP. JAPAN LTD.) * Zusammenfassung, Figur 3 * | 1 | |

RECHERCHIERTE SACHGEBIETE (Int. Cl.4)

H 03 K 17/00
H 02 P 7/00

Der vorliegende Recherchenbericht wurde für alle Patentansprüche erstellt.

| Recherchenort | Abschlußdatum der Recherche | Prüfer |
|---|---|---|
| BERLIN | 29-05-1986 | WEIHS J.A. |